# EUROPÄISCHE PATENTSCHRIFT

(11) **EP 2 175 045 B1**
(45) Veröffentlichungstag und Bekanntmachung des Hinweises auf die Patenterteilung: **08.01.2014**
(21) Anmeldenummer: 09172720.6
(22) Anmeldetag: 09.10.2009
(51) Int. Cl.: C23C 16/40, C23C 16/448, F28F 19/02, C23C 16/455

(54) **CVD-Beschichtungsverfahren**
CVD coating process
Procédé de revêtement CVD

(30) Priorität: 10.10.2008 DE 102008050941
(43) Veröffentlichungstag der Anmeldung: 14.04.2010
(73) Patentinhaber: Behr GmbH & Co. KG, 70469 Stuttgart (DE)
(72) Erfinder: Conrad, Nadine, 70469 Stuttgart (DE); Holzmann, Frank, 71732 Tamm (DE); Schaper, Jörg, 70806, Kornwestheim (DE); Holler, Sebastian, 70825 Korntal-Münchingen (DE)
(74) Vertreter: Grauel, Andreas

(56) Entgegenhaltungen:
- EP-A1- 0 030 638
- WO-A2-2008/017382
- US-A- 4 582 480
- US-A- 4 791 005
- US-A- 5 702 532
- US-A1- 2007 212 850

## Beschreibung

Die Erfindung betrifft ein CVD-Beschichtungsverfahren zum Herstellen eines Bauteils, insbesondere einer Fluldführung, welches Bauteil mindestes eine Fläche aufweist, die mit einer Beschichtung versehen wird, wobei das Bauteil mit der temperierten Fläche in unbeschichtetem Zustand zur Verfügung gestellt wird; die temperierte Fläche mit einem temperierten und mit mindestes einer reaktiven Komponente beladenen Fluidstrom aus Trägergas und Reaktivkomponente beaufschlagt wird, und der Fluidstrom auf der temperierten Fläche zu mindestens einer korrosionshemmenden Schicht in Form einer SiOₓ-Schicht reagiert.

Ein vorgenanntes CVD-Beschichtungsverfahren ist hinsichtlich seiner Grundlagen grundsätzlich bekannt aus der Halbleitertechnologie, beispielsweise aus dem Artikel von Nguyen et all, "Reaction Mechanisms of Plasma- and Thermal-Assisted Chemical Vapor Deposition of Tetraethylorthosilicate Oxide Films", im J. Electrochem. Soc., Vol. 137, No. 7, Pg. 2209 - 2215, (July 1990). Dargestellt ist ein plasma- und thermisch-assistierter CVD-Prozess, welcher als Reaktivgase TEOS (Tetraethylorthosilikat) und Ozon bzw. Sauerstoff verwendet.

In US 5,360,646 wird ein CVD-Verfahren zum Aufbringen von Siliziumoxidschichten auf eine Halbleiteroberfläche beschrieben. Dazu wird entweder gasförmiges TEOS und gasförmige Essigsäure und Wasserdampf oder gasförmiges TEOS und Wasserstoffperoxid in einem Stauerstoffträgergasstrom oder gasförmiges TEOS und flüssiges Wasserstoffperoxid mit gasförmigem Sauerstoff vermischt.

DE 197 08 808 A1 beschreibt ein Verfahren und eine Vorrichtung zum Aufbringen von transparenten, hochtemperaturbeständigen, interferenzfähigen Schutzschichten für Glasuren und Dekore bei dem eine Siliziumoxidschicht in Form von Quarz aufgebracht wird. Als Reaktivgas wird eine Verbindung aus Silizium und einer Monocarbonsäure, z. B. Siliziumtetraacetat, verwendet. Das Reaktivgas wird in einem vorgeschalteten Reaktor erzeugt und über ein Trägergas in den Beschichtungsofen geleitet.

Die US 2007/0212850 A1 offenbart ein Verfahren zum Füllen von Lücken mit Silikon enthaltendem Material.

Solche und andere bekannte CVD-Verfahren zum Aufbringen einer eingangs genannten SiOₓ-Schicht haben einen vergleichsweise hohen apparativen Aufwand, welcher unter Umständen Hochvakuum, Hochtemperatur, Inertgas oder eine Plasmaaktivierung erforderlich macht, während jedenfalls die oben genannten Verfahren immerhin bei Atmosphärendruck arbeiten.

Wünschenswert ist ein Verfahren, das mit vergleichsweise geringem apparativem Aufwand und bei vergleichsweise wenig aufwendigen Verfahrensparametern dennoch eine zuverlässige korrosionshemmende Schicht in Form einer SiOₓ-Schicht auf einem Bauteil einer Fluidführung erzeugen kann.

Dazu wurde in WO 2008/017382 von der Anmelderin ein bereits verbessertes Verfahren zur Herstellung eines Bauteils einer Fluidführung im Rahmen eines CVD-Beschichtungsverfahrens beschrieben. Als Chemikalien zur Erzeugung einer Siliziumoxidschicht wurden unter anderem Silane, Siliziumtetrachlorid und siliziumorganische Verbindungen, wozu auch TEOS und Siliziumtetraacetat zählen, beschrieben. Insbesondere eignet sich das dort beschriebene und eingangs genannte CVD-Beschichtungsverfahren zum Herstellen eines Wärmetauschers und/oder eines Bauteils in der umgebenden Fluidführung eines Wärmetauschers. Es hat sich gezeigt, dass ein derartiges von der Anmelderin beschriebenes Verfahren der WO 2008/017382 noch verbesserungswürdig ist. An dieser Stelle setzt die Erfindung an, deren Aufgabe es ist ein CVD-Beschichtungsverfahren, anzugeben, das vergleichsweise einfach realisierbar ist und dennoch zu einer verbesserten Korrosionshemmung mittels einer SiOx-Schicht auf dem Bauteil führt.

Hinsichtlich des Verfahrens wird die Aufgabe durch die Erfindung mittels einem CVD-Beschichtungsverfahren der eingangs genannten Art gelöst, bei dem erfindungsgemäß
- das Trägergas ein sauerstoffenthaltendes Gas ist;
- eine erste Reaktivkomponente eine siliziumorganische Verbindung ist, und
- eine zweite Reaktivkomponente eine wasser-basierte Komponente ist, wobei die wasser-basierte Komponente Wasser in unterstöchiometrischer Menge, insbesondere katalytischer Menge, enthält.

Die Erfindung geht von der Überlegung aus, dass eine verbesserte Abstimmung von Trägergas, erster Reaktivkomponente und zweiter Reaktivkomponente im Hinblick auf zu beschichtende Bauteile, insbesondere Fluidführung, insbesondere im Hinblick auf einen Wärmetauscher und/oder ein Bauteil in der umgebenden Fluidführung eines Wärmetauschers, zu einer verbesserten korrosionshemmenden SiOₓ-Schicht auf dem Bauteil führt. So hat die Erfindung in Bezug auf die DE 197 08 808 A1 und US 5,360,646 erkannt, dass sich als zweite Reaktivkomponente eine wasserbasierte Komponente besser eignet als Essigsäure. Darüber hinaus hat die Erfindung in Bezug auf US 5,360,646 erkannt, dass das dort beschriebene Verfahren ohne Trägergase arbeitet, sich aber ein Trägergas in Form eines Sauerstoff enthaltenden Gases besonders vorteilhaft eignet zusammen mit einer ersten Reaktivkomponente in Form einer siliziumorganischen Verbindung und einer zweiten Reaktivkomponente in Form einer wasserbasierten Komponente. Diese Kombination von Reaktivkomponenten mit Trägergas in Form von Sauerstoff hat sich gemäß der Erkenntnis der Erfindung besonders bewährt gegenüber anderen nicht so gut funktionierenden Verfahren wie in DE 197 08 808 A1 beschrieben. Außerdem hat das Konzept der vorliegenden Erfindung beispielsweise in Bezug auf den Artikel von S. Nguyen den Vorteil, dass bei thermisch assistiertem CVD Ozon als Reaktivgas vermieden werden kann, da Ozon einen erhöhten anlagentechnischen Aufwand mit sich bringt.

Letztendlich führt das Konzept der Erfindung zu einer erheblichen Vereinfachung im Vergleich zu bisher bekannten Verfahren und zu einer Verbesserung der Korrosionsbeständigkeit eines beschichteten Bauteils. Insbesondere wird eine Verbesserung der Korrosionsbeständigkeit aufgrund einer verbesserten Adaption der Beschichtung auf einer Oberfläche, insbesondere einer Rohrinnenseite von Wärmetauscherrohren, insbesondere bei Wärmetauschern, erreicht.

Für das Konzept der vorliegenden Erfindung nützlich ist eine CVD-Beschichtungsvorrichtung, die aufweist:
- ein Behältnis, insbesondere ein Ofen, für das Bauteil;
- ein erstes Vorlagebehältnis für die erste Reaktivkomponente einer siliziumorganischen Verbindung;
- ein zweites Vorlagebehältnis für die zweite Reaktivkomponente einer wasser-basierten Komponente;
- wenigstens eine Fluidleitung von dem ersten und zweiten Vorlagebehältnis zum Behältnis, insbesondere Ofen.

Es hat sich gezeigt, dass eine solche CVD-Beschlchtungsvorrichtung in besonders vorteilhafter Weise hinsichtlich der Beschichtungsparameter eingestellt werden kann.

Das Konzept der Erfindung führt hinsichtlich des Bauteils auf ein Bauteil, insbesondere einer Fluidführung, gemäß der eingangs genannten Art, insbesondere einen Wärmetauscher und/oder ein Bauteil in der umgebenden Fluidführung eines Wärmetauschers. Ein Bauteil, das gemäß dem oben beschriebenen Beschichtungsverfahren hergestellt ist, weist eine verbesserte Korrosionsbeständigkeit auf, insbesondere im Vergleich zu Bauteilen, welche - wie In US 5,360,646 oder DE 197 08 808 A1 - mit einer zweiten Reaktivkomponente in Form von Essigsäure anstatt einer wasserbasierten Komponente beschichtet wurden.

Vorteilhafte Weiterbildungen der Erfindung sind den Unteransprüchen zu entnehmen und geben im Einzelnen vorteilhafte Möglichkeiten an, das oben erläuterte Konzept im Rahmen der Aufgabenstellung, sowie hinsichtlich weiterer Vorteile zu realisieren.

Im Rahmen einer besonders bevorzugten Weiterbildung des erfindungsgemäßen Konzepts hat sich gezeigt, dass es mit erheblichen Vorteilen versehen ist, wenn die siliziumorganische Verbindung im Wesentlichen in Form von TEOS (Tetraethylorthosilikat) gebildet ist. Zusätzlich oder alternativ kann die siliziumorganische Verbindung auch Silioxane oder Siliziumtetraacetat enthalten.

Im Rahmen einer weiteren besonders bevorzugten Weiterbildung ist vorgesehen, dass die zweite Reaktivkomponente frei von Essigsäure ist.

Es hat sich insbesondere gezeigt, dass die wasser-basierte Komponente Wasser in gasförmiger Form enthält. Erfindungsgemäß ist die wasserbasierte Komponente derart quantifiziert, dass Wasser in unterstöchiometrischer Menge enthalten Ist. Damit ist gemeint, dass Wasser in unterstöchiometrischer Menge enthalten ist, als es für die als solche bekannte Beschichtungsreaktion - beispielsweise beschrieben in dem Artikel von Nguyen - notwendig wäre. Gemäß dieser Weiterbildung wurde vorteilhaft erkannt, dass die bei der Beschichtung stattfindende Reaktion Wasser bildet, so dass die Reaktion selbsterhaltend ist solange eine zum Starten der Reaktion unterstöchiometrische Menge von Wasser zur Verfügung gestellt wird. Insofern hat sich vorteilhaft gezeigt, dass gegebenenfalls auch eine lediglich katalytische Menge von Wasser in der wasser-basierten Komponente ausreichend ist zur Ausführung einer ausreichenden Beschichtungsreaktion.

Im Rahmen weiteren besonders bevorzugten Weiterbildung hat sich gezeigt, dass das Trägergas in besonders vorteilhafter Weise Luft ist, insbesondere hat es sich als vorteilhaft erwiesen, dass das Trägergas frei von Ozon ist, weil dadurch weiterer Anlagenaufwand vermieden wird. Gegebenenfalls kann ein Trägergas in Form einer Luft-Ozonmischung verwendet werden, ohne dass jedoch Ozon in überwiegender Menge vorliegt. Zusätzlich kann das Trägergas Helium enthalten.

Es hat sich gezeigt, dass im Rahmen des vorliegenden CVD-Beschichtungsverfahrens eine Temperierung der zu beschichtenden Fläche sowohl thermisch-assistiert als auch plasma-assistiert erfolgen kann. Besonders einfach lässt sich eine thermisch-assistierte Temperierung im Rahmen einer Weiterbildung realisieren.

Darüber hinaus kann im Rahmen von weiteren Weiterbildungen das Konzept der Erfindung hinsichtlich der Fluidströme mit zusätzlichen Vorteilen versehen werden. So hat es sich als vorteilhaft erwiesen, dass die siliziumorganische Verbindung, insbesondere TEOS, und die wasser-basierte Komponente, insbesondere Wasser, insbesondere Wasserdampf, in getrennten Fluidströmen auf jeweils einem separaten Trägergas einem das Bauteil enthaltenden Behältnis zugeführt werden. Betreffend die CVD-Beschichtungsvorrichtung ist dazu vorteilhaft vorgesehen, dass das erste und zweite Vorlagebehältnis in einer Parallelschaltung der Trägergasführung angeordnet sind.

Im Rahmen einer dazu alternativen Weiterbildung der Erfindung hat es sich als vorteilhaft erwiesen, dass die siliziumorganische Verbindung, insbesondere TEOS, und die wasser-basierte Komponente, insbesondere Wasser, in einem einzigen Fluidstrom auf einem einzigen Trägergas einem das Bauteil enthaltenden Behältnis zugeführt werden. Im Rahmen der CVD-Beschichtungsvorrichtung hat es sich dazu als vorteilhaft ergeben, dass das erste und zweite Vorlagebehältnis in einer Reihenschaltung der Trägergasführung angeordnet sind.

Beide zuvor beschriebenen Weiterbildungen lassen sich je nach Zweckmäßigkeit ausführen, dabei hat die auf einer Parallelschaltung von Trägergasführung beruhende Weiterbildung den Vorteil, dass die erste und zweite Reaktivkomponente weitgehend unabhängig voneinander gesteuert werden können. Die auf der Reihenschaltung basierende Weiterbildung hat den Vorteil, dass diese besonders einfach ausgelegt werden kann.

Das erste und/oder zweite Vorlagebehältnis der Beschichtungsvorrichtung ist vorteilhaft als "Bubbler" ausgelegt. Darüber hinaus kann das erste und/oder zweite Vorlagebehältnis mit einer einstellbaren Temperatur temperierbar sein. Im Rahmen des Beschichtungsverfahrens lässt sich dadurch die Konzentration der Reaktivkomponente in Bezug auf das Trägergas besonders einfach einstellen.

Im Rahmen einer ganz besonders vorteilhaften Weiterbildung des Beschichtungsverfahrens ist vorgesehen, dass ein Fluidstrom aus Trägergas und Reaktivkomponente einem das Bauteil enthaltenden Behältnis als Ringstrom, insbesondere als strömungsrichtung-umkehrbarer Ringstrom, geführt wird. Betreffend die Beschichtungsvorrichtung ist gemäß dieser Weiterbildung vorgesehen, dass wenigstens eine Fluidleitung von dem ersten und zweiten Vorlagebehältnis zu dem das Bauteil enthaltenden Behältnis eine Ringleitung umfasst, mit welcher der Ofen fluidbeströmbar, insbesondere fluidrichtungsumkehrbar fluidbeströmbar ist.

Vorteilhaft weist die Ringleitung dazu eine Strömungsumkehrvorrichtung, z.B. in Form einer geeigneten Armatur, auf. Es hat sich gemäß der Erkenntnis dieser Weiterbildung gezeigt, dass mit einer Ringleitung eine besonders einfache den Erfordernissen anpassbare Beschichtungssteuerung ermöglicht wird. Insbesondere kann mit einer umkehrbar beströmbaren Ringleitung erreicht werden, dass sich eine verhältnismäßig gleichmäßige Beschichtung über das gesamte Bauteil erzielen lässt. Bedingt durch die Abreaktion des Reaktivgases steht am Ende des Durchströmbauteils grundsätzlich weniger Reaktivgas für die Beschichtung zur Verfügung, was üblicherweise zu einer reduzierten bzw. ungleichmäßigen Schichtdicke führen kann. Durch Umkehrung des Fluidstroms in angemessenen Taktabständen, beispielsweise gesteuert durch eine Strömungsumkehrvorrichtung mit Hilfe von Ventilen od.dgl. lässt sich dies vermeiden und der zuvor genannte Vorteil realisieren.

Im Rahmen einer weiteren besonders bevorzugten Weiterbildung der Beschichtungsvorrichtung lässt sich die Ausbeute der bei dem Beschichtungsverfahren und der Beschichtungsvorrichtung vorgesehenen Reaktiv- und Trägerfluide erheblich erhöhen. Die Weiterbildung sieht dazu vor, dass die wenigstens eine Fluidleitung mit einer Temperaturregelung versehen ist, welche eine Temperatur oberhalb einer Temperatur des ersten und/oder zweiten Vorlagebehältnisses vorsieht. Dadurch wird nicht nur eine Einstellung der Konzentration der Reaktivkomponenten im Vorlagebehältnis unterstützt, sondern auch der Transport der Reaktivkomponenten zum Bauteil effektiv gestaltet. Weiter ist gemäß einer bevorzugten Weiterbildung vorgesehen, dass das Behältnis mit einer - selbigen und weiteren - Temperaturregelung versehen ist, welche nur das Bauteil bei einer Beschichtungstemperatur hält. Insbesondere kann dazu vorgesehen sein, dass das Bauteil in einem fluiddurchströmbaren mit der Fluidleitung verbundenen und temperierbaren Behältnis in den Ofen eingebracht wird. Das Behältnis kann das Bauteil, insbesondere vergleichsweise eng umgeben. Eine Beschichtungstemperatur ist insbesondere zwischen 300°C und 500°C vorgesehen. Somit wird die eigentliche Beschichtungsreaktion aufgrund der Temperaturgestaltung in Fluidleitung, Bauteilbehältnis und direkt am Bauteil so gestaltet, dass diese auf das Bauteil konzentriert ist. Dazu ist insbesondere vorgesehen, dass ein temperierter und mit mindestens einer reaktiven Komponente beladener Fluidstrom aus Trägergas und Reaktivkomponente zu der temperierten Fläche geführt wird.

Grundsätzlich eignet sich das CVD-Beschichtungsverfahren und/oder die CVD-Beschichtungsvorrichtung zur Beschichtung aller Arten von Bauteilen, insbesondere einer Fluidführung. Insbesondere lässt sich das CVD-Beschichtungsverfahren und/oder die CVD-Beschichtungsvorrichtung auslegen auf Wärmetauscher und/oder Bauteile in der umgebenden Fluidführung eines Wärmetauschers. Dies betrifft insbesondere Wärmetauscher wie sie in der Peripherie von Verbrennungsmaschinen, insbesondere für automotive Anwendungen, zum Einsatz kommen.

Vorteilhaft ist ein Wärmetauscher zum Wärmetausch zwischen einem ersten Fluid einerseits, auch insbesondere einem Abgas und/oder einer Ladeluft, und einem zweiten Fluid andererseits, insbesondere einem Kühlmittel, ausgelegt. Vorteilhaft weist ein solcher Wärmetauscher auf:
- einen Block zur voneinander getrennten und wärmetauschenden Führung des ersten und des zweiten Fluids, mit
- einer Anzahl von dem ersten Fluid durchströmbaren Strömungskanälen,
- eine erste die Strömungskanäle aufnehmende, von dem zweiten Fluid durchströmbare Kammer,
- ein Gehäuse, in dem die Kammer und die Strömungskanäle angeordnet sind.

Im Rahmen einer besonders bevorzugten Weiterbildung hat sich gezeigt, dass mit dem CVD-Beschichtungsverfahren und/oder der CVD-Beschichtungsvorrichtung ausgewählte Flächen eines Wärmetauschers im Vergleich zum Stand der Technik besonders vorteilhaft beschichtet werden können. Dazu macht die beschichtete Fläche einen Teil des Wärmetauschers aus, insbesondere:
- einen Block ganz oder teilweise; und/oder
- wenigstens einen Strömungskanal ganz oder teilweise, insbesondere eine Innenseite des Strömungskanals; und/oder
- Strömungsleitelemente, insbesondere am Strömungskanal, ganz oder teilweise; und/oder
- einen Rohrboden ganz oder teilweise, und/oder
- ein Gehäuse ganz oder teilweise.

Vorteilhaft ist, dass das erste und/oder zweite Vorlagebehältnis als "Bubbler" ausgelegt ist.

Vorteilhaft ist, dass das erste und/oder zweite Vorlagebehältnis mit einer einstellbaren Temperatur temperierbar sind.

Vorteilhaft ist, dass wenigstens eine Fluidleitung von dem ersten und zweiten Vorlagebehältnis zum Ofen eine Ringleitung umfasst, mit welcher der Ofen fluidbeströmbar, insbesondere fluidrichtungsumkehrbar fluidbeströmbar ist, insbesondere eine Strömungsumkehrvorrichtung aufweist.

Vorteilhaft ist, dass die wenigstens eine Fluidleitung mit einer Temperaturregelung versehen ist, welche eine Temperatur vorsieht, die höher als eine Temperatur des ersten und/oder zweiten Vorlagebehältnisses ist.

Vorteilhaft ist, dass das erste und/oder zweite Vorlagebehältnis mit einer Temperaturregelung versehen ist und/oder das Behältnis, insbesondere der Ofen mit einer Temperaturregelung versehen ist, welche nur das Bauteil bei einer Beschichtungstemperatur, insbesondere bei einer Beschichtungstemperatur zwischen 300°C und 500°C hält.

Vorteilhaft ist ein Bauteil in Form eines Wärmetauschers zum Wärmetausch zwischen einem ersten Fluid einerseits, insbesondere einem Abgas und/oder einer Ladeluft und einem zweiten Fluid andererseits, insbesondere einem Kühlmittel, insbesondere aufweisend:
- einen Block zur voneinander getrennten und wärmetauschenden Führung des ersten und des zweiten Fluids, mit
- einer Anzahl von dem ersten Fluid durchströmbaren Strömungskanälen,
- eine erste die Strömungskanäle aufnehmende, von dem zweiten Fluid durchströmbare Kammer,
- ein Gehäuse, in dem die Kammer und die Strömungskanäle angeordnet sind.

Vorteilhaft ist, dass die beschichtete Fläche einen Teil des Wärmetauschers ausmacht, insbesondere
- einen Block ganz oder teilweise; und/oder
- wenigstens einen Strömungskanal ganz oder teilweise, insbesondere eine Innenseite des Strömungskanals; und/oder
- Strömungsleitelemente, insbesondere am Strömungskanal, ganz oder teilweise; und/oder
- einen Rohrboden ganz oder teilweise, und/oder
- ein Gehäuse ganz oder teilweise.

Ausführungsbeispiele der Erfindung werden nun nachfolgend anhand der Zeichnung beschrieben. Diese soll die Ausführungsbeispiele nicht notwendigerweise maßstäblich darstellen, vielmehr ist die Zeichnung, wo zur Erläuterung dienlich, in schematisierter und/oder leicht verzerrter Form ausgeführt. Im Hinblick auf Ergänzungen der aus der Zeichnung unmittelbar erkennbaren Lehren wird auf den einschlägigen Stand der Technik verwiesen. Dabei ist zu berücksichtigen, dass vielfältige Modifikationen und Änderungen betreffend die Form und das Detail einer Ausführungsform vorgenommen werden können, ohne von der allgemeinen Idee der Erfindung abzuweichen. Die in der Beschreibung, in der Zeichnung sowie in den Ansprüchen offenbarten Merkmale der Erfindung können sowohl einzeln als auch in beliebiger Kombination für die Weiterbildung der Erfindung wesentlich sein. Zudem fallen in den Rahmen der Erfindung alle Kombinationen aus zumindest zwei der in der Beschreibung, der Zeichnung und/oder den Ansprüchen offenbarten Merkmale. Die allgemeine Idee der Erfindung ist nicht beschränkt auf die exakte Form oder das Detail der im folgenden gezeigten und beschriebenen bevorzugten Ausführungsform oder beschränkt auf einen Gegenstand, der eingeschränkt wäre im Vergleich zu dem in den Ansprüchen beanspruchten Gegenstand. Bei angegebenen Bemessungsbereichen sollen auch innerhalb der genannten Grenzen liegende Werte als Grenzwerte offenbart und beliebig einsetzbar und beanspruchbar sein.

Im Einzelnen zeigt die Zeichnung in:
- Fig. 1:: eine erste bevorzugte Ausführungsform einer CVD-Beschichtungsvorrichtung und/oder eines CVD-Beschichtungsverfahrens im Rahmen des Konzepts der Erfindung mit einer Parallelschaltung des ersten und zweiten Vorlagebehältnisses;
- Fig. 2:: eine zweite Ausführungsform einer CVD-Beschichtungsvorrichtung und/oder eines CVD-Beschichtungsverfahrens im Rahmen des Konzepts der Erfindung mit einer Reihenschaltung des ersten und zweiten Vorlagebehältnisses;
- Fig. 3:: eine besonders bevorzugte schematische Darstellung einer CVD-Beschichtungsvorrichtung und/oder eines CVD-Beschichtungsverfahrens mit einer Fluidführung als umkehrbarer Ringstrom, wobei eine solche Fluidführung auch bei der anhand von Fig. 1 und Fig. 2 gezeigten ersten und zweiten Ausführungsform eingesetzt werden kann;
- Fig. 4:: ein beispielhaftes Korrosions-Testergebnis, welches die Vorteile des erfindungsgemäßen Konzepts im Vergleich zum Stand der Technik-Verfahren verdeutlicht.

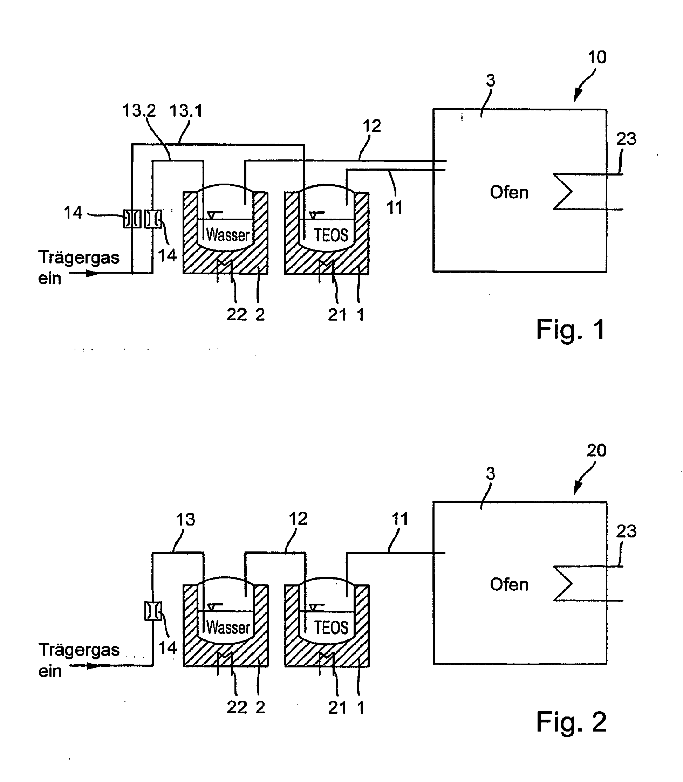

Fig. 1 zeigt im Rahmen einer ersten Ausführungsform eine CVD-Beschichtungsvorrichtung 10, aufweisend: ein Behältnis in Form eines Ofens 3 für das nicht näher dargestellte zu beschichtende Bauteil; ein erstes Vorlagebehältnis 1 in Form eines Bubblers, welches für die erste Reaktivkomponente einer vorliegend in Form von TEOS-gebildeten siliziumorganischen Verbindung vorgesehen ist; ein zweites Vorlagebehältnis 2 in Form eines Bubblers, welches für die zweite Reaktivkomponente einer wasser-basierten Komponente, vorliegend in Form von Wasser, vorgesehen ist, sowie vorliegend separate und parallel geführte Fluidleitungen 11, 12 für TEOS bzw. Wasserdampf von dem ersten Vorlagebehältnis 1 und dem zweiten Vorlagebehältnis 2 zum Ofen 3. Die Bubbler werden jeweils über mit Ventilen 14 versehene Trägergasleitungen 13.1 und 13.2 mit Trägergas versorgt, welches unterhalb der Oberfläche der Reaktivkomponente eingeblasen wird. Die Bubbler selbst sind über eine Heizung 22, 21 temperierbar. Der Ofen 3 wird über eine Heizung 23 beheizt.

In den so temperierten Vorlagebehältnissen 1, 2 wird TEOS bzw. Wasser bei einer Temperatur unterhalb der jeweiligen Siedetemperatur vorgelegt. Durch beide Vorlagebehältnisse 1, 2 wird als Trägergas Luft in der oben dargestellten Weise geleitet, die sich in den Bubblern mit dem dort verdampfenden Stoff - im Vorlagebehältnis 1 TEOS und im Vorlagebehältnis 2 Wasser - sättigt. Das Wasser wird nur in katalytischer Menge benötigt, da bei der im Beschichtungsofen 3 stattfindenden Reaktion wieder Wasser gebildet wird. Über die Temperatur des jeweiligen Bubblers lässt sich die Konzentration der jeweiligen Stoffkomponente in der Gasphase einstellen. Die beiden Gasströme mit gesättigtem TEOS und Wasser werden jeweils in einer temperierten Fluidleitung 11 bzw. temperierten Fluidleitung 12 in den Beschichtungsofen 3 geleitet - wie erläutert im Rahmen der Parallelschaltung der Vorlagebehältnisse 1, 2, ohne dass die beiden Gasströme mit gesättigtem TEOS und Wasser vorgemischt werden. Die Fluidleitungen 11, 12 sind mittels einer Temperaturregelung auf einer Temperatur gehalten, welche oberhalb einer Temperatur des jeweiligen ersten und/oder zweiten Vorlagebehältnisses 1, 2 liegt. Dies führt zu einer besonders vorteilhaften Gasführung in den Fluidleitungen 11, 12.

Fig. 2 zeigt als eine zweite alternative bevorzugte Ausführungsform eine CVD-Beschichtungsvorrichtung 20.

Gleiche oder ähnliche Merkmale oder Merkmale gleicher oder ähnlicher Funktion sind dabei und im Folgenden der Einfachheit halber mit gleichen Bezugszeichen versehen.

Bei der in Fig. 2 dargestellten CVD-Beschichtungsvorrichtung wird - im Unterschied zur CVD-Beschichtungsvorrichtung 10 - mit nur einem Trägergasstrom in Form eines Luftstroms gearbeitet. Dieser wird in einer Trägergasleitung 13 zunächst in das zweite Vorlagebehältnis 2 geleitet, in dem Wasser zur Vorlage kommt, und dann wird das mit Wasser beladene Trägergas über die Fluidleitung 12 in das erste Vorlagebehältnis geleitet, in welchem TEOS vorgehalten wird. Somit wird das Trägergas der Leitung 13 zunächst im zweiten Bubbler mit der zweiten Reaktivkomponente angereichert, wobei die Konzentrationseinstellung über die mit Heizung 22 bewerkstelligte Temperierung erfolgt. Der so gesättigte Gasstrom aus Trägergas und zweiter Reaktivkomponente wird über die Fluidleitung 12 durch den ersten Bubbler zur Anreicherung mit der ersten Reaktivkomponente geleitet. Das Trägergas mit beiden Reaktivkomponenten wird dann über die Fluidleitung 11 dem Beschichtungsofen 3 zugeführt.

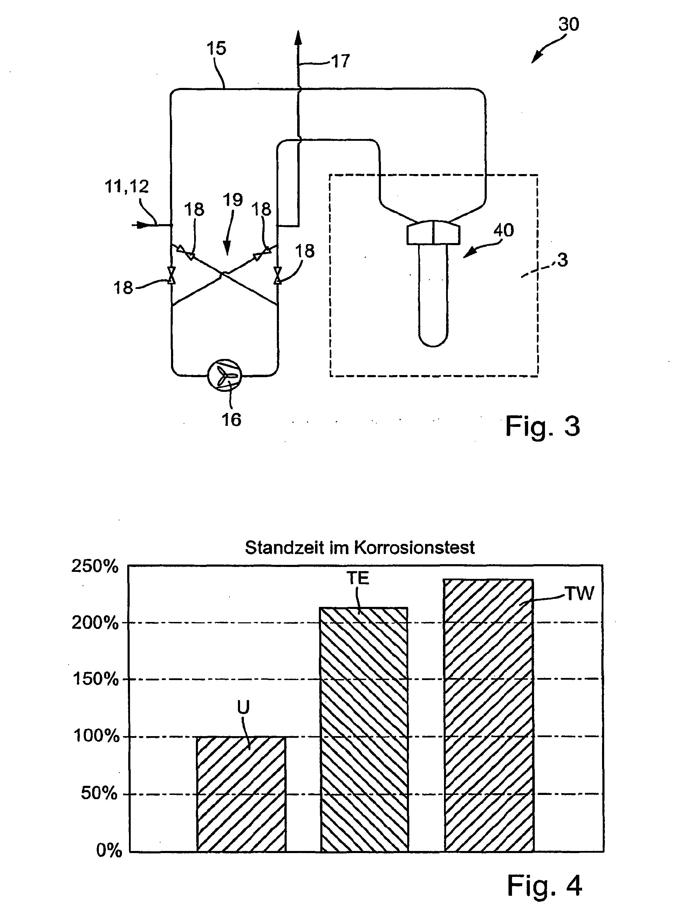

In Fig. 3 ist eine dritte Ausführungsform einer CVD-Beschichtungsvorrichtung 30 gezeigt, die in Kombination mit einer ersten oder zweiten CVD-Beschichtungsvorrichtung 10, 20 der Fig. 1 und Fig. 2 eingesetzt werden kann. Die Fig. 3 zeigt dazu den Einlass einer Fluidleitung 11 und/oder einer Fluidleitung 12 in eine Ringleitung 15. Mittels der Ringleitung 15 wird der Ofen 3 beströmt. Die Ringleitung 15 weist eine Abgasleitung 17 und eine Strömungsumkehrvorrichtung 19 mit einer entsprechenden Anordnung von Ventilen 18 sowie ein Gebläse 16 auf. Das Gebläse 16 sorgt dafür, dass das in der Ringleitung 15 befindliche Fluid umgewälzt wird. Die in Fig. 3 gezeigte Ausführungsform einer CVD-Beschichtungsvorrichtung 30 eignet sich in besonders bevorzugter Weise für zu beschichtende komplizierte Strukturen von Bauteilen, wie z.B. einem Wärmetauscher für eine Verbrennungsmaschine. Der Wärmetauscher 40 ist vorliegend symbolisch im Ofen 3 dargestellt. Insbesondere eignet sich die CVD-Beschichtungsvorrichtung 30 auch zur Beschichtung einer Rohrinnenseite von Wärmetauscherrohren bei einem Wärmetauscher 40.

Die oben beschriebene Ringleitung 15 wird in einem auf die CVD-Beschichtungsvorrichtung 30 ausgelegten CVD-Beschichtungsverfahren auf eine Temperatur oberhalb der Temperatur der vorliegend nicht näher dargestellten aber ähnlich wie in Fig. 1 oder Fig. 2 angeordneten Bubbler eingestellt.

Das vorliegend als Wärmetauscher 40 vorgesehene Bauteil ist dicht in die in den Ofen 3 einragende Ringleitung 15 eingebaut, so dass nur der Wärmetauscher 40 auf eine vorliegende Beschichtungstemperatur zwischen 300°C bis 500°C gebracht ist. Dazu mündet vorliegend die Ringleitung in ein den Wärmetauscher 40 lang umgebendes Behältnis, das in den Ofen 3 eingebracht ist. Gleichwohl ist die Bauteil-Temperatur mit dem temperierbaren Behältnis vom Ofen 3 und dem Beschichtungsfluid gehalten. Dies hat den Vorteil, dass die Beschichtung auch nur an dem Wärmetauscher 40 aufgebracht wird, was die Ausbeute bei dem Verfahren gemäß der CVD-Beschichtungsvorrichtung 30 deutlich erhöht.

Bedingt durch die Abreaktion des Reaktivgases aus dem Einlass der Fluidleitung 11, 12 - im oberen Teil des Wärmetauschers 40 - steht am Ende des durchströmten Bauteils - am unteren Teil des Wärmetauschers weniger Reaktivgas für die Beschichtung zur Verfügung was zu einer reduzierten bzw. ungleichmäßigen Schichtdicke führen könnte. Mit Hilfe der Strömungsumkehrvorrichtung 19 kann diesem entgegengewirkt werden bzw. sicher verhindert werden. Die Strömungsrichtung des Fluids wird dazu in der Ringleitung 15 umgekehrt - regelmäßig führt dies zu einer gleichmäßigen Beschichtung über das gesamte Bauteil, vorliegend in Form eines Wärmetauschers 40.

Insgesamt hat sich gezeigt, dass ein mit dem CVD-Beschichtungsverfahren und/oder der CVD-Beschichtungsvorrichtung 10, 20, 30 beschichtetes Bauteile unter Verwendung von sauerstoffhaltigen Gas als Trägergas und einer ersten sowie zweiten Reaktivkomponente in Form von TEOS und Wasser ein verbesserter Korrosionsschutz erzielt wird.

In Fig. 4 ist dazu eine Standzeit im Korrosionstest bei einem Bauteil, das gemäß dem Konzept der vorliegenden Erfindung beschichtet wurde (TW) im Vergleich zu einem Bauteil, das mit TEOS und Essigsäure als Reaktivkomponenten beschichtet wurde (TE) und einem unbeschichteten Bauteil (U) gezeigt. Es hat sich herausgestellt, dass mit dem Verfahren und/oder der Vorrichtung gemäß dem Konzept der Erfindung nicht nur eine lokale Aufbringung einer korrosionshemmenden SiOₓ-Schicht, z.B. auf einer Rohrinnenseite eines Wärmetauscherrohres oder ähnlich schwierig zugänglichem dreidimensionalen Bauteil möglich ist, sondern auch mit sehr hoher Ausbeute. Dies führt zu einer Verbesserung der Standzeit, welche deutlich über einer Verdopplung der Standzeit im Korrosionstest im Vergleich zu einem unbeschichteten Bauteil führt (TW, U) und liegt damit selbst über Ergebnissen, die mit Reaktivkomponenten in Form von TEOS und Essigsäure (TE) erzielt wurden.

Zusammenfassend betrifft die Erfindung CVD-Beschichtungsverfahren zum Herstellen eines Bauteiles einer Fluidführung, insbesondere zum Herstellen eines Wärmetauschers 40 und/oder eines Bauteiles in der umgebenden Fluidführung eines Wärmetauschers 40, welches Bauteil mindestens eine Fläche aufweist, die mit einer Beschichtung versehen wird, wobei
- das Bauteil mit der temperierten Fläche in unbeschichtetem Zustand zur Verfügung gestellt wird;
- eine temperierte Fläche mit einem temperierten Fluidstrom beaufschlagt wird, insbesondere ein temperierter und mit mindestens einer reaktiven Komponente beladener Fluidstrom aus Trägergas und Reaktivkomponente zu der temperierten Fläche geführt wird, und
- der Fluidstrom auf der temperierten Fläche zu mindestens einer korrosionshemmenden Schicht in Form einer SiOx-Schicht reagiert;
dadurch gekennzeichnet, dass
- das Trägergas ein Sauerstoff enthaltendes Gas ist,
- eine erste Reaktivkomponente eine siliziumorganische Verbindung ist, und
- eine zweite Reaktivkomponente eine wasser-basierte Komponente ist, wobei die wasser-basierte Komponente Wasser in unter-stöchiometrischer Menge enthält.

### Bezugszeichenliste

- 1: erstes Vorlagebehältnis
- 2: zweites Vorlagebehältnis
- 3: Ofen, Beschichtungsofen
- 11, 12: Fluidleitungen
- 13, 13.1, 13.2: Trägergasleitungen
- 14, 18: Ventilen
- 15: Ringleitung
- 16: Gebläse
- 17: Abgasleitung
- 19: Strömungsumkehrvorrichtung, Strömungsumkehrarmatur
- 21,22,23: Heizung
- 10, 20, 30: CVD-Beschichtungsvorrichtung
- 40: Wärmetauscher

## Patentansprüche

1. CVD-Beschichtungsverfahren (10, 20, 30) zum Herstellen eines Bauteiles, insbesondere einer Fluidführung, insbesondere zum Herstellen eines Wärmetauschers (40) und/oder eines Bauteiles in der umgebenden Fluldführung eines Wärmetauschers (40), welches Bauteil mindestens eine Fläche aufweist, die mit einer Beschichtung versehen wird, wobei
- das Bauteil mit der temperierten Fläche in unbeschichtetem Zustand zur Verfügung gestellt wird;
- die temperierte Fläche mit einem temperierten und mit mindestens einer reaktiven Komponente beladenen Fluidstrom aus Trägergas und Reaktivkomponente beaufschlagt wird, und
- der Fluidstrom auf der temperierten Fläche zu mindestens einer korrosionshemmenden Schicht in Form einer SiOₓ-Schicht reagiert;
**dadurch gekennzeichnet, dass**
- das Trägergas ein Sauerstoff enthaltendes Gas ist,
- eine erste Reaktivkomponente eine siliziumorganische Verbindung ist, und
- eine zweite Reaktivkomponente eine wasser-basierte Komponente ist, wobei die wasser-basierte Komponente Wasser in unterstöchiometrischer Menge, insbesondere katalytischer Menge, enthält.

2. CVD-Beschichtungsverfahren nach Anspruch 1 **dadurch gekennzeichnet, dass**
die siliziumorganische Verbindung im Wesentlichen in Form von TEOS (TetraEthylOrthoSilicat) gebildet ist.

3. CVD-Beschichtungsverfahren nach Anspruch 1 oder 2 **dadurch gekennzeichnet, dass**
die siliziumorganische Verbindung Siloxane und/oder Siliziumtetraacetat enthält.

4. CVD-Beschichtungsverfahren nach einem der Ansprüche 1 bis 3 **dadurch gekennzeichnet, dass**
eine Temperierung der Fläche und/oder des Fluidstroms thermisch assistiert und/oder plasma assistiert erfolgt.

5. CVD-Beschichtungsverfahren nach einem der Ansprüche 1 bis 4 **dadurch gekennzeichnet, dass**
das Trägergas Luft, insbesondere frei von Ozon, ist oder Luft mit Ozon ist.

6. CVD-Beschichtungsverfahren nach einem der Ansprüche 1 bis 5 **dadurch gekennzeichnet, dass**
das Trägergas Helium enthält.

7. CVD-Beschichtungsverfahren nach einem der Ansprüche 1 bis 6 **dadurch gekennzeichnet, dass**
die wasser-basierte Komponente Wasser in gasförmiger Form enthält.

8. CVD-Beschichtungsverfahren nach einem der Ansprüche 1 bis 7 **dadurch gekennzeichnet, dass**
die silizlumorganische Verbindung, insbesondere TEOS, und die wasser-basierte Komponente, insbesondere Wasser, in getrennten Fluidströmen auf jeweils einem separaten Trägergas einem das Bauteil enthaltenden Behältnis, insbesondere einem Ofen (3), zugeführt werden.

9. CVD-Beschichtungsverfahren nach einem der Ansprüche 1 bis 8 **dadurch gekennzeichnet, dass** die sitiziumorganische Verbindung, insbesondere TEOS, und die wasser-basierte Komponente, insbesondere Wasser, in einem einzigen Fluidstrom auf einem einzigen Trägergas einem das Bauteil enthaltenden Behältnis, insbesondere einem Ofen (3), zugeführt werden.

10. CVD-Beschichtungsverfahren nach einem der Ansprüche 1 bis 9 **dadurch gekennzeichnet, dass**
ein Fluidstrom aus Trägergas und der ersten und zweiten Reaktivkomponente einem das Bauteil enthaltenden Behältnis, als Ringstrom, insbesondere als Strömungsrichtung umkehrbarer Ringstrom, geführt wird.

## Claims

1. A CVD coating method (10, 20, 30) for producing a component, in particular a fluid guide, especially for producing a heat exchanger (40) and/or a component in the surrounding fluid guide of a heat exchanger (40), the component having at least one surface provided with a coating, with:
- the component being provided with the temperature-controlled surface in the uncoated state;
- the temperature-controlled surface being subjected to fluid flow that is temperature-controlled and to a fluid flow charged with at least one reactive component and comprises a carrier gas and a reactive component; and
- the fluid flow on the temperature-controlled surface reacting to form at least one corrosion-inhibiting layer in the form of a SiOx layer;
**characterized in that**
- the carrier gas is an oxygen-containing gas;
- a first reactive component is an organosilicon compound; and
- a second reactive component is a water-based component, wherein the water-based component comprises water in a substoichiometric quantity, in particular in a catalytic quantity.

2. The CVD coating method according to claim 1, **characterized in that** the organosilicon compound is essentially formed as TEOS (tetraethyl orthosilicate).

3. The CVD coating method according to claim 1 or 2, **characterized in that** the organosilicon compound comprises siloxanes and/or silicon tetraacetate.

4. A CVD coating method according to any one of claims 1 to 3, **characterized in that** a temperature control of the surface and/or of the fluid flow takes place in a thermally assisted and/or plasma-assisted manner.

5. A CVD coating method according to any one of claims 1 to 4, **characterized in that** the carrier gas is air, in particular free of ozone, or air comprising ozone.

6. A CVD coating method according to any one of claims 1 to 5, **characterized in that** the carrier gas comprises helium.

7. A CVD coating method according to any one of claims 1 to 6, **characterized in that** the water-based component comprises water in gaseous form.

8. A CVD coating method according to any one of claims 1 to 7, **characterized in that** the organosilicon compound, in particular TEOS, and the water-based component, in particular water, are supplied in separate fluid flows on a respective separate carrier gas to a container comprising the component, in particular a furnace (3).

9. A CVD coating method according to any one of claims 1 to 8, **characterized in that** the organosilicon compound, in particular TEOS, and the water-based component, in particular water, are supplied in a single fluid flow on a single carrier gas to a container comprising the component, in particular a furnace (3).

10. A CVD coating method according to any one of claims 1 to 9, **characterized in that** a fluid flow comprising carrier gas and the first and second reactive components is supplied to a container comprising the component as a ring current, in particular as a ring current the flow direction of which can be reversed.

## Revendications

1. Procédé de revêtement CVD (10, 20, 30) réalisé par dépôt en phase vapeur obtenu par procédé chimique et servant à la fabrication d'un élément de construction, en particulier d'un guidage de fluide, en particulier servant à la fabrication d'un échangeur de chaleur (40) et/ou d'un élément de construction placé dans le guidage de fluide environnant d'un échangeur de chaleur (40), élément de construction qui présente au moins une surface qui est dotée d'un revêtement, où
- l'élément de construction comportant la surface tempérée est fourni dans un état non revêtu;
- la surface tempérée est alimentée par un flux de fluide tempéré et chargé d'au moins un composant réactif, ledit flux de fluide se composant d'un gaz porteur et d'un composant réactif, et
- le flux de fluide réagit, sur la surface tempérée, pour former au moins une couche protégeant contre la corrosion et se présentant sous la forme d'une couche de SiOₓ;
**caractérisé en ce que**
- le gaz porteur est un gaz contenant de l'oxygène,
- un premier composant réactif est un composé organique de silicium, et
- un deuxième composant réactif est un composant à base d'eau, où le composant à base d'eau contient de l'eau suivant une quantité sous-stoechiométrique, en particulier suivant une quantité catalytique.

2. Procédé de revêtement CVD selon la revendication 1, **caractérisé en ce que** le composé organique de silicium est constitué essentiellement sous la forme d'un composé TEOS (orthosilicate de tétraéthyle).

3. Procédé de revêtement CVD selon la revendication 1 ou 2, **caractérisé en ce que** le composant organique de silicium contient des siloxanes et/ou du tétraacétate de silicium.

4. Procédé de revêtement CVD selon l'une quelconque des revendications 1 à 3, **caractérisé en ce qu'**un équilibrage de la température de la surface et/ou du flux de fluide se produit en étant assisté thermiquement et/ou en étant assisté par plasma.

5. Procédé de revêtement CVD selon l'une quelconque des revendications 1 à 4, **caractérisé en ce que** le gaz porteur est de l'air, en particulier de l'air sans ozone, ou bien de l'air avec de l'ozone.

6. Procédé de revêtement CVD selon l'une quelconque des revendications 1 à 5, **caractérisé en ce que** le gaz porteur contient de l'hélium.

7. Procédé de revêtement CVD selon l'une quelconque des revendications 1 à 6, **caractérisé en ce que** le composant à base d'eau contient de l'eau se présentant sous forme gazeuse.

8. Procédé de revêtement CVD selon l'une quelconque des revendications 1 à 7, **caractérisé en ce que** le composé organique de silicium, en particulier le composé TEOS, et le composant à base d'eau, en particulier de l'eau, sont fournis, dans des flux de fluide séparés, respectivement sur un gaz porteur distinct, à un récipient, en particulier à un four (3) contenant l'élément de construction.

9. Procédé de revêtement CVD selon l'une quelconque des revendications 1 à 8, **caractérisé en ce que** le composé organique de silicium, en particulier le composé TEOS, et le composant à base d'eau, en particulier de l'eau, sont fournis, dans un flux de fluide unique, sur un gaz porteur unique, à un récipient, en particulier à un four (3) contenant l'élément de construction.

10. Procédé de revêtement CVD selon l'une quelconque des revendications 1 à 9, **caractérisé en ce qu'**un flux de fluide se composant d'un gaz porteur et du premier et du deuxième composant réactif est fourni à un récipient contenant l'élément de construction, comme un flux annulaire, en particulier comme un flux annulaire à direction d'écoulement pouvant être inversée.
